# EUROPEAN PATENT APPLICATION

(11) **EP 4 765 203 A1**
(43) Date of publication of application: **24.06.2026**
(21) Application number: 24864100.3
(22) Date of filing: 20.05.2024
(51) Int. Cl.: H01L 23/48

(54) **CHIP PACKAGING STRUCTURE, PREPARATION METHOD THEREFOR, AND ELECTRONIC DEVICE**

(30) Priority: 15.09.2023 CN 202311205689
(71) Applicant: HUAWEI TECHNOLOGIES CO., LTD., Shenzhen 518129 (CN)
(72) Inventor: YEH, Steven, Shenzhen, Guangdong 518129 (CN); TANG, Jiajie, Shenzhen, Guangdong 518129 (CN); LIAO, Jun, Shenzhen, Guangdong 518129 (CN); HUANG, Jiang, Shenzhen, Guangdong 518129 (CN)
(74) Representative: Epping - Hermann - Fischer
(86) International application number: PCT/CN2024/094306
(87) International publication number: WO 2025/055375

(57) **Abstract**

Embodiments of this application disclose a chip packaging structure and a preparation method thereof, and an electronic device, and relate to the field of semiconductor technologies. The chip packaging structure includes a packaging substrate, a first component, a second component, and an elevating assembly. The packaging substrate has a first surface and a second surface. The first component is connected to the first surface. The second component and the elevating assembly are connected to the second surface. The elevating assembly includes a fastening layer and a plurality of conductive pillars, and the conductive pillars extend in a direction perpendicular to the second surface. The fastening layer surrounds a partial side surface of each conductive pillar, to limit displacement of the conductive pillar. A surface of a side that is of the conductive pillar and that is close to the packaging substrate is connected to the second surface. The fastening layer fastens the plurality of conductive pillars, so that the elevating assembly can be used as a single part. In a process of connecting the conductive pillar to the packaging substrate, the plurality of conductive pillars may be simultaneously connected to the second surface, without a need to mount the plurality of conductive pillars one by one. This helps improve a yield of the chip packaging structure.

## Description

This application claims priority to Chinese Patent Application No. 202311205689.7, filed with the China National Intellectual Property Administration on September 15, 2023 and entitled "CHIP PACKAGING STRUCTURE AND PREPARATION METHOD THEREOF, AND ELECTRONIC DEVICE", which is incorporated herein by reference in its entirety.

### TECHNICAL FIELD

Embodiments of this application relate to the field of semiconductor technologies, and in particular, to a chip packaging structure and a preparation method thereof, and an electronic device.

### BACKGROUND

With development of a packaging technology, a requirement for miniaturization of a chip packaging structure is increasing, and a chip packaging technology gradually changes from single-side packaging to dual-side packaging (dual side molding, DSM). The dual-side packaging means that chips are mounted on two opposite surfaces of a packaging substrate. This means that the dual-side packaging can carry more chips and implement more functions.

However, the chips are disposed on both surfaces of the packaging substrate, which increases difficulty of leading out an I/O end on the packaging substrate, and reduces a yield of the chip packaging structure.

### SUMMARY

Embodiments of this application provide a chip packaging structure and a preparation method thereof, and an electronic device, to improve a yield of the chip packaging structure.

To achieve the foregoing objectives, the following technical solutions are used in embodiments of this application.

According to a first aspect, a chip packaging structure is provided, where the chip packaging structure includes a packaging substrate, a first component, a second component, and an elevating assembly. The packaging substrate has a first surface and a second surface that are opposite to each other. The first component is connected to the first surface. The second component and the elevating assembly are connected to the second surface. The elevating assembly includes a fastening layer and a plurality of conductive pillars, and the conductive pillars extend in a direction perpendicular to the second surface. The fastening layer surrounds a partial side surface of each conductive pillar, to limit displacement of the conductive pillar. A material of the fastening layer includes a liquid crystal polymer or an inorganic material. A surface of a side that is of the conductive pillar and that is close to the packaging substrate is connected to the second surface. A spacing between the second surface and a surface of a side that is of the conductive pillar and that is away from the packaging substrate is greater than a spacing between the second surface and a surface of a side that is of the second component and that is away from the packaging substrate.

According to the chip packaging structure provided in some embodiments of this application, the elevating assembly is disposed on the second surface of the packaging substrate, and an I/O end of the packaging substrate may be led out by using the conductive pillar in the elevating assembly. This means that in this embodiment of this application, the solder ball may be replaced with a solder dot preform between the conductive pillar and the packaging substrate, and an elevating board may be replaced with the conductive pillar, so that problems caused by the solder ball and the elevating board can be eliminated, improving a yield of the chip packaging structure. Therefore, the elevating assembly in this embodiment of this application can be used in both a scenario with a large elevating height and a scenario with a small spacing between balls (for example, the ball spacing is less than 0.35 mm).

In addition, in this embodiment of this application, the fastening layer is disposed, and the fastening layer is used to surround a partial side surface of each conductive pillar, to fasten each conductive pillar. The elevating assembly including the fastening layer and the plurality of conductive pillars may be used as an independent module. In this way, in a process of connecting the conductive pillar to the packaging substrate, the elevating assembly may be used as a single part for operation, so that the plurality of conductive pillars in the elevating assembly may be soldered to the packaging substrate at a time, thereby alleviating a phenomenon like tilting, falling-down, or bending of the conductive pillar caused by one-by-one mounting of the conductive pillar, avoiding damage to the conductive pillar, improving a yield and electrical performance of the chip packaging structure, and improving a yield of soldering between the chip packaging structure and the circuit board.

In addition, the fastening layer is prepared and formed by using a material like a liquid crystal polymer or an inorganic material, and therefore, costs are low. This can avoid greatly increasing preparation costs of the chip packaging structure.

In a possible implementation of the first aspect, there are a plurality of elevating assemblies, and the plurality of elevating assemblies are located on at least two sides of the second component. In this way, the different elevating assemblies can be used to lead out the I/O end of the packaging substrate while forming relatively balanced and stable support for the packaging substrate, thereby improving structural stability between the chip packaging structure and the circuit board.

In a possible implementation of the first aspect, there are a plurality of fastening layers, and the plurality of fastening layers are spaced apart and stacked in a direction perpendicular to the second surface. This helps increase stability or consistency between the conductive pillars, improve structural stability of the elevating assembly, and further improve a connection yield between the elevating assembly and the packaging substrate.

In a possible implementation of the first aspect, there is a gap between the fastening layer and the second surface of the packaging substrate. In this way, the surface of the side that is of the conductive pillar and that is close to the packaging substrate can be in an exposed state, to facilitate soldering between the conductive pillar and the packaging substrate. In addition, when the second surface of the packaging substrate is molded, it can be ensured that a molding material can be filled in the gap between the fastening layer and the second surface, thereby improving a yield of the chip packaging structure.

In a possible implementation of the first aspect, a spacing between the second surface and a surface of a side that is of the conductive pillar and that is away from the packaging substrate is greater than a spacing between the second surface and a surface of a side that is of the fastening layer and that is away from the packaging substrate. In this way, the surface of the side that is of the conductive pillar and that is away from the packaging substrate can be in an exposed state, to facilitate soldering between the conductive pillar and the circuit board. In a possible implementation of the first aspect, the chip packaging structure further includes a first packaging layer. The first packaging layer is connected to the second surface, and is at least filled in a gap between two adjacent conductive pillars, and surrounds a side surface of each conductive pillar. A second packaging layer further wraps the fastening layer. The first packaging layer can not only provide physical protection for the second component and the elevating assembly, but also fasten the second component and the elevating assembly on the packaging substrate, to improve structural stability between the second component and the packaging substrate, and improve structural stability between the elevating assembly and the packaging substrate. This helps improve quality and a yield of the chip packaging structure.

In a possible implementation of the first aspect, a material of the second packaging layer is different from a material of the fastening layer. For example, the material of the second packaging layer is of a different type from the material of the fastening layer. For another example, the material of the second packaging layer and the material of the fastening layer are of a same type, and have different filling materials.

According to a second aspect, a chip packaging structure is provided. The chip packaging structure includes a packaging substrate, a first component, a second component, an elevating assembly, and a first packaging layer. The packaging substrate has a first surface and a second surface that are opposite to each other. The first component is connected to the first surface. The second component, the elevating assembly, and the first packaging layer are connected to the second surface. The elevating assembly includes a fastening layer and a plurality of conductive pillars, and the conductive pillars extend in a direction perpendicular to the second surface. The fastening layer surrounds a partial side surface of each conductive pillar, to limit displacement of the conductive pillar. A spacing between the second surface and a surface of a side that is of the conductive pillar and that is away from the packaging substrate is greater than a spacing between the second surface and a surface of a side that is of the second component and that is away from the packaging substrate. The first packaging layer is at least filled in a gap between two adjacent conductive pillars, and surrounds each conductive pillar. The first packaging layer further wraps the fastening layer.

According to the chip packaging structure provided in some embodiments of this application, the elevating assembly is disposed on the second surface of the packaging substrate, and an I/O end of the packaging substrate may be led out by using the conductive pillar in the elevating assembly. This means that in this embodiment of this application, a solder ball may be replaced with a solder dot preform between the conductive pillar and the packaging substrate, and an elevating board may be replaced with the conductive pillar, so that problems caused by the solder ball and the elevating board can be eliminated, a yield of the chip packaging structure can be improved, and the elevating assembly in this embodiment of this application can be used in both a scenario with a large elevating height and a scenario with a small spacing between balls (for example, the ball spacing is less than 0.35 mm).

In addition, in this embodiment of this application, the fastening layer is disposed, and the fastening layer is used to surround a partial side surface of each conductive pillar, to fasten each conductive pillar. The elevating assembly including the fastening layer and the plurality of conductive pillars may be used as an independent module. In this way, in a process of connecting the conductive pillar to the packaging substrate, the elevating assembly may be used as a single part for operation, so that the plurality of conductive pillars in the elevating assembly may be soldered to the packaging substrate at a time, thereby alleviating a phenomenon like tilting, falling-down, or bending of the conductive pillar caused by one-by-one mounting of the conductive pillar, avoiding damage to the conductive pillar, improving a yield and electrical performance of the chip packaging structure, and improving a yield of soldering between the chip packaging structure and the circuit board.

In addition, the first packaging layer is disposed, so that structural stability between the elevating assembly and the packaging substrate can be improved, thereby improving reliability of the chip packaging structure.

In a possible implementation of the second aspect, there are a plurality of elevating assemblies, and the plurality of elevating assemblies are located on at least two sides of the second component. In this way, the different elevating assemblies can be used to lead out the I/O end of the packaging substrate while forming relatively balanced and stable support for the packaging substrate, thereby improving structural stability between the chip packaging structure and the circuit board.

In a possible implementation of the second aspect, there are a plurality of fastening layers, and the plurality of fastening layers are spaced apart and stacked in a direction perpendicular to the second surface. This helps increase stability or consistency between the conductive pillars, improve structural stability of the elevating assembly, and further improve a connection yield between the elevating assembly and the packaging substrate.

In a possible implementation of the second aspect, there is a gap between the fastening layer and the second surface of the packaging substrate. In this way, the surface of the side that is of the conductive pillar and that is close to the packaging substrate can be in an exposed state, to facilitate soldering between the conductive pillar and the packaging substrate. In addition, when the second surface of the packaging substrate is molded, it can be ensured that a molding material can be filled in the gap between the fastening layer and the second surface, thereby improving a yield of the chip packaging structure.

In a possible implementation of the second aspect, a spacing between the second surface and a surface of a side that is of the conductive pillar and that is away from the packaging substrate is greater than a spacing between the second surface and a surface of a side that is of the fastening layer and that is away from the packaging substrate. In this way, the surface of the side that is of the conductive pillar and that is away from the packaging substrate can be in an exposed state, to facilitate soldering between the conductive pillar and the circuit board.

In a possible implementation of the second aspect, a material of the fastening layer includes a liquid crystal polymer or a resin material. The material of the fastening layer includes an insulation material, so that short-circuiting between different conductive pillars can be avoided.

According to a third aspect, a preparation method for a transistor is provided, where the preparation method includes: providing a packaging body, where the packaging body includes a packaging substrate, a first component, and a second component, the packaging substrate has a first surface and a second surface that are opposite to each other, the first component is connected to the first surface, and the second component is connected to the second surface; forming an elevating assembly, where the elevating assembly includes a fastening layer and a plurality of conductive pillars, the conductive pillars extend in a direction perpendicular to the second surface, and the fastening layer surrounds a partial side surface of each conductive pillar, to limit displacement of the conductive pillar; and connecting each conductive pillar in the elevating assembly to the second surface, where a spacing between the second surface and a surface of a side that is of the conductive pillar and that is away from the packaging substrate is greater than a spacing between the second surface and a surface of a side that is of the second component and that is away from the packaging substrate.

According to the preparation method provided in some embodiments of this application, the conductive pillar is connected to the fastening layer to form the elevating assembly, and the fastening layer can be used to fasten the conductive pillar, so that the elevating assembly including the fastening layer and the plurality of conductive pillars is used as an independent module. Further, in a process of connecting the conductive pillar to the second surface of the packaging substrate, the elevating assembly may be used as a single part for operation, so that the plurality of conductive pillars in the elevating assembly may be synchronously connected to the second surface, thereby alleviating a phenomenon like tilting, falling-down, or bending of the conductive pillar caused by one-by-one mounting of the conductive pillar. This avoids damage to the conductive pillar, improves a yield of the chip packaging structure, and improves a yield of soldering between the chip packaging structure and the circuit board.

In a possible implementation of the third aspect, forming the elevating assembly includes: providing the plurality of conductive pillars, where the plurality of conductive pillars are spaced, and each conductive pillar extends in a same direction; and forming the fastening layer that surrounds the partial side surface of each conductive pillar.

In a possible implementation of the third aspect, the preparation method further includes: forming a first packaging layer on the second surface. The first packaging layer is at least filled in a gap between two adjacent conductive pillars, and surrounds a side surface of each conductive pillar. The first packaging layer further wraps the fastening layer.

According to a fourth aspect, an electronic device is provided. The electronic device includes a circuit board and a chip packaging structure electrically connected to the circuit board. The chip packaging structure includes the chip packaging structure according to any implementation of the first aspect or the second aspect.

For technical effect brought by the fourth aspect, refer to technical effect brought by different design manners in the first aspect. Details are not described herein again.

### BRIEF DESCRIPTION OF DRAWINGS

FIG. 1 is a diagram of a structure of an electronic device according to an embodiment of this application;
FIG. 2 is a diagram of a partial structure of an electronic device according to an embodiment of this application;
FIG. 3 is another diagram of a partial structure of an electronic device according to an embodiment of this application;
FIG. 4 is still another diagram of a partial structure of an electronic device according to an embodiment of this application;
FIG. 5 is a diagram of a structure of a chip packaging structure according to an embodiment of this application;
FIG. 6 is a bottom view of a chip packaging structure according to an embodiment of this application;
FIG. 7 is another bottom view of a chip packaging structure according to an embodiment of this application;
FIG. 8 is another diagram of a structure of a chip packaging structure according to an embodiment of this application;
FIG. 9 is still another diagram of a structure of a chip packaging structure according to an embodiment of this application;
FIG. 10 is still another diagram of a structure of a chip packaging structure according to an embodiment of this application;
FIG. 11 is still another diagram of a structure of a chip packaging structure according to an embodiment of this application;
FIG. 12 is still another diagram of a structure of a chip packaging structure according to an embodiment of this application;
FIG. 13 is still another diagram of a partial structure of an electronic device according to an embodiment of this application;
FIG. 14 is a flowchart of a preparation method for a chip packaging structure according to an embodiment of this application;
FIG. 15A to FIG. 15E are diagrams of structures corresponding to steps in a preparation method for a chip packaging structure according to an embodiment of this application;
FIG. 16A and FIG. 16B are diagrams of structures corresponding to steps in another preparation method for a chip packaging structure according to an embodiment of this application; and
FIG. 17A and FIG. 17B are diagrams of structures corresponding to steps in still another preparation method for a chip packaging structure according to an embodiment of this application.

### DESCRIPTION OF EMBODIMENTS

The following describes technical solutions in embodiments of this application with reference to accompanying drawings in embodiments of this application. It is clear that the described embodiments are merely some but not all of embodiments of this application. All other embodiments obtained by a person of ordinary skill in the art based on embodiments of this application fall within the protection scope of this application.

In descriptions of embodiments of this application, "a plurality of" means two or more than two, unless otherwise specified. "At least one item (piece)" or a similar expression thereof indicates any combination of these items, including a single item (piece) or any combination of a plurality of items (pieces). For example, at least one item (piece) of a, b, and c may represent a, b, c, a-b, a-c, b-c, or a-b-c, where a, b, and c may be singular or plural. "a and/or b" includes the following three combinations: only a, only b, and a combination of a and b.

In addition, to clearly describe technical solutions in embodiments of this application, in embodiments of this application, words such as "first" and "second" are used to distinguish same items or similar items that have basically same functions and effects. A person skilled in the art may understand that the terms such as "first" and "second" do not limit a quantity or an execution sequence, and the terms such as "first" and "second" do not indicate a definite difference. In addition, in embodiments of this application, terms such as "example" or "for example" are used to give an example, an illustration, or a description. Any embodiment or design solution described as "example" or "for example" in embodiments of this application should not be explained as being more preferred or having more advantages than another embodiment or design solution. Exactly, use of the terms such as "example" or "for example" is intended to present a related concept in a specific manner for ease of understanding.

In the description of some embodiments, expressions of "connection" and extensions thereof are used. The term "connection" should be understood in a broad sense. For example, the "connection" may be a fixed connection, a detachable connection, or an integral connection, or may be a direct connection or an indirect connection implemented through an intermediate medium. In addition, the use of "based on" means openness and inclusiveness, since processes, steps, calculation, or other actions "based on" one or more of conditions or values may be based in practice on additional conditions or values outside the described values.

As used herein, "parallel", "perpendicular to", and "equal to" include described cases and similar cases. A range of a similar case is in an acceptable deviation range. The acceptable deviation range is determined by a person of ordinary skill in the art by considering an error (namely, a limitation of a measurement system) related to measurement being discussed and measurement of a specific quantity. For example, "parallel" includes "absolutely parallel" and "approximately parallel", and an acceptable deviation range of "approximately parallel" may be, for example, a deviation within 5°. "Perpendicular to" includes "absolutely perpendicular to" and "approximately perpendicular to", and an acceptable deviation range of "approximately perpendicular to" may also be, for example, a deviation within 5°. "Equal to" includes "absolutely equal to" and "approximately equal to". An acceptable deviation range of "approximately equal to" may be that, for example, a difference between two equal objects is less than or equal to 5% of either of the two objects.

In embodiments of this application, "up" and "down" are not limited to orientations schematically placed relative to components in the accompanying drawings. It should be understood that these directional terms may be relative concepts, and are used for relative description and clarification, and may correspondingly change based on changes in placement orientations of the components in the accompanying drawings. In the accompanying drawings, for clarity, thicknesses of layers and regions are exaggerated, and a size proportion relationship between parts in the figures does not reflect an actual size proportion relationship. Therefore, a change in a shape in the accompanying drawings due to, for example, manufacturing techniques and/or tolerances may be envisaged. Therefore, example implementations should not be construed as being limited to a shape of a region shown in this application, but rather include shape deviations due to, for example, manufacturing. For example, an etching region shown as a rectangle typically has a bending characteristic. Therefore, the regions shown in the accompanying drawings are essentially examples, and their shapes are not intended to show actual shapes of regions of a device, and are not intended to limit a scope of the example implementations.

In addition, an architecture and a scenario described in embodiments of this application are intended to describe the technical solutions in embodiments of this application more clearly, and do not constitute a limitation on the technical solutions provided in embodiments of this application. A person of ordinary skill in the art may know that with evolution of the architecture and emergence of new scenarios, the technical solutions provided in embodiments of this application are also applicable to similar technical problems.

An embodiment of this application provides an electronic device. The electronic device may be a mobile phone (mobile phone), a tablet computer (pad), a television, a desktop computer, a laptop computer, a handheld computer, a notebook computer, an ultra-mobile personal computer (ultra-mobile personal computer, UMPC), a netbook, a cellular phone, a personal digital assistant (personal digital assistant, PDA), an augmented reality (augmented reality, AR) device, a virtual reality (virtual reality, VR) device, an artificial intelligence (artificial intelligence, AI) device, a smart wearable device (for example, a smartwatch or a smart band), a vehicle-mounted device, a smart home device, and/or a smart city device, and a specific type of the electronic device is not specifically limited in embodiments of this application.

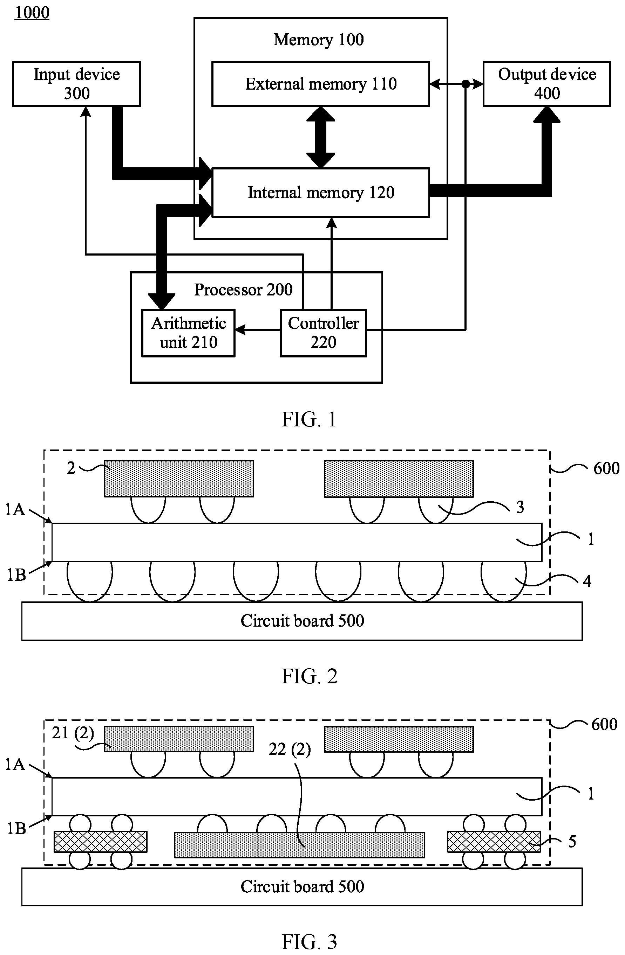

FIG. 1 is a diagram of an architecture of an electronic device according to an embodiment of this application. As shown in FIG. 1, the electronic device 1000 includes components such as a memory 100, a processor 200, an input device 300, and an output device 400. A person skilled in the art may understand that a structure of the electronic device shown in FIG. 1 does not constitute any limitation on the electronic device 1000, and the electronic device 1000 may include more or fewer components than those shown in FIG. 1, or may combine some of the components shown in FIG. 1, or may have a different component arrangement from that shown in FIG. 1.

The memory 100 is configured to store a software program and a module. The memory 100 mainly includes a program storage region and a data storage region. The program storage region may store an operating system, an application required by at least one function (such as a sound playing function and an image playing function), and the like. The data storage region may store data (such as audio data, image data, and a phone book) created based on use of the electronic device, and the like. In addition, the memory 100 includes an external memory 110 and an internal memory 120. Data stored in the external memory 110 and the internal memory 120 may be transmitted to each other. The external memory 110 includes, for example, a hard disk, a USB flash drive, and a floppy disk. The internal memory 120 includes, for example, a static random access memory (static random access memory, SRAM), a dynamic random access memory (dynamic random access memory, DRAM), a read-only memory, and the like.

The processor 200 is a control center of the electronic device 1000, and connects various parts of the entire electronic device 1000 through various interfaces and lines. By running or executing the software program and/or the module that are/is stored in the memory 100, and invoking data stored in the memory 100, the processor 200 performs various functions of the electronic device 1000 and processes data, to perform overall monitoring on the electronic device 1000. Optionally, the processor 200 may include one or more processing units. For example, the processor 200 may include a central processing unit (central processing unit, CPU), an artificial intelligence (artificial intelligence, AI) processor, a digital signal processor (digital signal processor, DSP), and a neural-network processing unit, or may be another application-specific integrated circuit (application-specific integrated circuit, ASIC). In FIG. 1, an example in which the processor 200 is a CPU is used, and the CPU may include an arithmetic unit 210 and a controller 220. The arithmetic unit 210 obtains data stored in the internal memory 120, and processes the data stored in the internal memory 120. A processing result is usually sent back to the internal memory 120. The controller 220 may control the arithmetic unit 210 to process the data, and the controller 220 may further control the external memory 110 and the internal memory 120 to store data or read data. The memory 100 may store data generated by the processor 200.

The input device 300 is configured to receive input number or character information, and generate a key signal input related to user settings and function control of the electronic device 1000. For example, the input device 300 may include a touchscreen and another input device. The touchscreen, also referred to as a touch panel, may collect a touch operation performed by a user on the touchscreen or near the touchscreen (for example, an operation performed by the user on the touchscreen or near the touchscreen by using any proper object or accessory like a finger or a stylus pen), and drive a corresponding connection apparatus based on a preset program. Optionally, the touchscreen may include two parts: a touch detection apparatus and a touch controller. The touch detection apparatus detects a touch orientation of the user, detects a signal brought by the touch operation, and transfers the signal to the touch controller. The touch controller receives touch information from the touch detection apparatus, converts the touch information into touch point coordinates, sends the touch point coordinates to the processor 200, and can receive and execute a command sent by the processor 200. In addition, the touchscreen may be implemented in a plurality of types such as a resistive type, a capacitive type, an infrared ray type, and a surface acoustic wave type. The another input device may include but is not limited to one or more of a physical keyboard, a function key (such as a volume control key or a power on/off key), a trackball, a mouse, a joystick, or the like. The controller 220 in the processor 200 may further control the input device 300 to receive an input signal or not to receive an input signal. In addition, the input number or character information received by the input device 300 and the key signal input related to user settings and function control of the electronic device may be stored in the internal memory 120.

The output device 400 is configured to output a signal corresponding to data that is input by the input device 300 and stored in the internal memory 120. For example, the output device 400 outputs a sound signal or a video signal. The controller 220 in the processor 200 may further control the output device 400 to output a signal or not to output a signal.

It should be noted that a thick arrow in FIG. 1 indicates data transmission, and a direction of the thick arrow indicates a data transmission direction. For example, a unidirectional arrow between the input device 300 and the internal memory 120 indicates that data received by the input device 300 is transmitted to the internal memory 120. For another example, a bidirectional arrow between the arithmetic unit 210 and the internal memory 120 indicates that the data stored in the internal memory 120 may be transmitted to the arithmetic unit 210, and data processed by the arithmetic unit 210 may be transmitted to the internal memory 120. A thin arrow in FIG. 1 indicates a component that can be controlled by the controller 220. For example, the controller 220 may control the external memory 110, the internal memory 120, the arithmetic unit 210, the input device 300, the output device 400, and the like.

Optionally, the electronic device 1000 shown in FIG. 1 may further include various sensors, for example, a gyroscope sensor, a hygrometer sensor, an infrared sensor, and a magnetometer sensor. Details are not described herein. Optionally, the electronic device 1000 may further include a wireless fidelity (wireless fidelity, Wi-Fi) module, a Bluetooth module, and the like. Details are not described herein.

FIG. 2, FIG. 3, and FIG. 4 each show a partial structure of the electronic device 1000. As shown in FIG. 2 to FIG. 4, the electronic device 1000 may further include a circuit board 500 and a chip packaging structure 600. The chip packaging structure 600 is disposed on the circuit board 500, and is electrically connected to the circuit board 500.

In some examples, as shown in FIG. 2 to FIG. 4, the chip packaging structure 600 includes a packaging substrate 1, and the packaging substrate 1 has a first surface 1A and a second surface 1B that are opposite to each other.

For example, the packaging substrate 1 includes, for example, at least one dielectric layer and a plurality of metal layers. The dielectric layer and the metal layer are alternately stacked. The metal layer may also be referred to as a re-distributed layer. A via is disposed in the dielectric layer, and two metal layers located on two opposite sides of the dielectric layer are electrically connected through the via.

Optionally, the packaging substrate 1 includes but is not limited to an organic substrate, a ceramic substrate, and a silicon substrate.

The chip packaging structure 600 further includes a component, and the component includes a chip and/or a passive component. In other words, the component may be only a chip, may be only a passive component, or may include both a chip and a passive component.

With reference to the accompanying drawings, an example in which the component is a chip is used for description in this embodiment of this application.

As shown in FIG. 2 to FIG. 4, the chip packaging structure 600 further includes a chip 2. There is at least one chip 2. For example, there may be one, two, three, four, or even more chips 2.

In some embodiments of this application, the chip 2 may be a wafer (wafer) that has a function layer, or may be a die (die) obtained by dicing a wafer that has a function layer. The die may also be referred to as a die of the wafer. In some cases, the chip 2 may alternatively be a chip obtained by packaging the die. Based on this, in some embodiments, a plurality of chips 2 in the chip packaging structure 600 may all be dies or chips obtained by packaging the dies. In some other embodiments, the plurality of chips 2 in the chip packaging structure 600 may all be wafers. In some other embodiments, in the plurality of chips 2 in the chip packaging structure 600, some chips 2 may be wafers, and some chips 2 may be dies and/or chips obtained by packaging the dies.

For example, the function layer enables the chip 2 to implement a storage function, and correspondingly, the chip 2 is a memory chip. For another example, the function layer enables the chip 2 to implement a logical computing function, and correspondingly, the chip 2 is a processor chip.

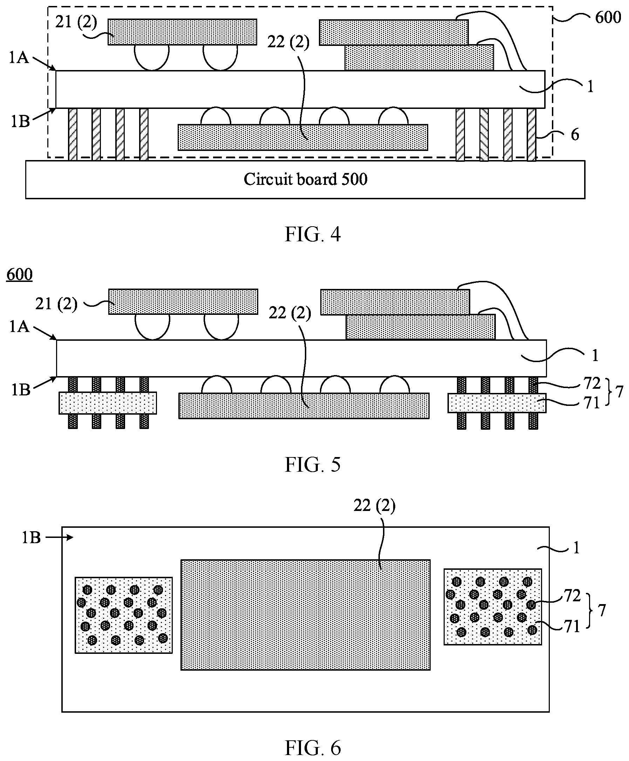

The chip packaging structure 600 shown in FIG. 2 is packaged by using a single-side packaging technology, and the chip packaging structure 600 shown in FIG. 3 and FIG. 4 is packaged by using a double-side packaging technology. Manners of disposing the chip 2 in different packaging technologies are different. The following provides schematic descriptions with reference to the accompanying drawings.

In the structure shown in FIG. 2, the chip 2 is located on the first surface 1A, and the circuit board 500 is located on the second surface 1B.

For example, the chip packaging structure 600 further includes a first connecting piece 3 disposed between the chip 2 and the first surface 1A, and the chip 2 is connected (or soldered) to the packaging substrate 1 through the first connecting piece 3. The first connecting piece 3 is, for example, a controlled collapse chip connection bump (controlled collapse chip connection bump, C4 bump). The chip packaging structure 600 further includes a second connecting piece 4 disposed between the circuit board 500 and the second surface 1B, and the circuit board 500 is connected (or soldered) to the packaging substrate 1 through the second connecting piece 4. The second connecting piece 4 may be, for example, a solder ball (which may also be referred to as a tin ball).

In this way, the chip 2 may be electrically connected to the circuit board 500 through the first connecting piece 3, the packaging substrate 1, and the second connecting piece 4 in sequence.

There is at least one chip 2. FIG. 2 shows two chips 2, and the two chips 2 are disposed side by side. Certainly, when there are a plurality of chips 2, the plurality of chips 2 may be sequentially stacked in a direction perpendicular to the first surface 1A.

In the structures shown in FIG. 3 and FIG. 4, the component includes a first component and a second component. For example, the first component includes a first chip 21, and the second component includes a second chip 22. The first chip 21 is located on the first surface 1A, and the second chip 22 is located on the second surface 1B.

A connection manner between the first chip 21 and the first surface 1A and a connection manner between the second chip 22 and the second surface 1B are, for example, the same as a connection manner between the chip 2 and the packaging substrate 1 in the foregoing single-side packaging technology. Details are not described herein again.

Further, an I/O end on the second surface 1B of the packaging substrate 1 is electrically connected to the circuit board 500. In this way, the first chip 21 and the second chip 22 can be electrically connected to the circuit board 500 through the packaging substrate 1 and the I/O end on the second surface 1B of the packaging substrate 1.

There is at least one first chip 21. For example, there may be one, two, three, four, or even more first chips 21. FIG. 3 shows two first chips 21, and the two first chips 21 are disposed side by side. FIG. 4 shows three first chips 21. In the three first chips 21, some first chips 21 are disposed side by side, and some first chips 21 are sequentially stacked in the direction perpendicular to the first surface 1A.

There is at least one second chip 22. For example, there may be one, two, three, four, or even more second chips 22. FIG. 3 shows one second chip 22. When there are a plurality of second chips 22, the plurality of second chips 22 may be disposed side by side, or may be sequentially stacked in the direction perpendicular to the second surface 1B.

Compared with the single-side packaging technology, the double-side packaging technology can increase an area that is of a chip and in which the packaging substrate 1 can be connected, so that the chip packaging structure 600 can carry more chips and implement more functions.

It may be understood that, in the double-side packaging technology, because the second chip 22 is disposed, a spacing between the packaging substrate 1 and the circuit board 500 is increased. Therefore, the packaging substrate 1 needs to be elevated, to lead out the I/O end on the second surface 1B of the packaging substrate 1.

In a possible implementation, the packaging substrate 1 is elevated by using a solder ball, to lead out the I/O end on the second surface 1B of the packaging substrate 1. That is, the I/O end on the second surface 1B of the packaging substrate 1 is electrically connected to the circuit board 500 through a solder ball. However, when a thickness (namely, a size that is of a device and that is in a direction perpendicular to the second surface 1B) of a device (including but not limited to the second chip 22 and a passive device) disposed on the second surface 1B is large, a ball diameter (ball diameter) of the solder ball needs to be increased. However, due to a limitation of a spacing (ball spacing) between different solder balls, a large ball diameter of the solder ball easily leads to short-circuiting between different solder balls, to reduce a yield of the chip packaging structure.

Therefore, in this embodiment of this application, FIG. 3 and FIG. 4 respectively show a manner of elevating the packaging substrate 1.

In FIG. 3, the chip packaging structure 600 further includes an elevating board (Frame board) 5 disposed on the second surface 1B of the packaging substrate 1. A plurality of solder balls are disposed on an upper surface of the elevating board 5, and the elevating board 5 is electrically connected to the second surface 1B of the packaging substrate 1 through the plurality of solder balls. A plurality of solder balls are disposed on a lower surface of the elevating board 5, and the elevating board 5 is electrically connected to the circuit board 500 through the plurality of solder balls.

The chip packaging structure 600 is elevated by using the elevating board 5 and the solder ball, so that ball diameters of the solder balls disposed on the upper and lower surfaces of the elevating board 5 can be reduced, and a risk of short-circuiting between different solder balls can be reduced, thereby improving a yield of the chip packaging structure.

However, as a thickness of a device disposed on the second surface 1B increases, the ball diameter of the solder ball still needs to be increased, and therefore, short-circuiting between different solder balls is still likely to occur. Due to a limitation of a ball diameter and a spacing between solder balls, when an elevating height is large (for example, the elevating height is greater than 0.5 mm) or the spacing between balls is small (for example, the ball spacing is less than 0.35 mm), process difficulty is greatly increased, and a scenario in which the elevating board 5 and the solder ball are used for elevating is limited.

In addition, when the solder ball has a large volume, the solder ball easily blocks a cleaning process (deflux) of a flux, resulting in incomplete water washing.

In addition, when molding (molding) is performed on the elevating board 5 and the solder ball, a solder overflow phenomenon is likely to occur on the solder ball between the elevating board 5 and the packaging substrate 1, and the chip packaging structure 600 fails; and in addition, the elevating board 5 or the solder ball is likely to affect a molding flow (molding flow), causing a void (void) or a filling problem.

In FIG. 4, the chip packaging structure 600 further includes a plurality of conductive pillars 6 disposed between the packaging substrate 1 and the circuit board 500. One end of the conductive pillar 6 is electrically connected to the second surface 1B of the packaging substrate 1, for example, by using a solder dot preform, and the other end of the conductive pillar 6 is electrically connected to the circuit board 500, for example, by using a solder dot preform.

The chip packaging structure 600 is elevated by using the conductive pillar 6, the solder dot preform may be used to replace the solder ball, and the conductive pillar 6 may be used to replace the elevating board 5, thereby eliminating problems caused by the solder ball and the elevating board 5, and improving a yield and electrical performance of the chip packaging structure 600. In addition, the conductive pillar 6 is used for elevating, and the conductive pillar 6 can be used in a scenario in which an elevating height is large, and can also be used in a scenario in which a ball spacing is less than 0.35 mm.

However, due to a limitation of a processing device, a surface mount technology (surface mount technology, SMT) of one-by-one mounting needs to be used to place the conductive pillars 6 one by one on the packaging substrate 1 to complete soldering. In this process, the conductive pillar 6 is easily tilted (tilt), falls down (fall down), bent (bending), and the like, damaging (damage) the conductive pillar 6. This reduces a yield of the chip packaging structure 600, and reduces a yield of soldering between the chip packaging structure 600 and the circuit board 500.

Based on this, an embodiment of this application further provides a manner of elevating the packaging substrate 1. As shown in FIG. 5, the chip packaging structure 600 further includes an elevating assembly 7. The elevating assembly 7 is connected to the second surface 1B of the packaging substrate 1.

Still refer to FIG. 5. The elevating assembly 7 includes a plurality of conductive pillars 72. A material of the conductive pillar 72 includes a metal material, and the metal material is, for example, copper. In this case, the conductive pillar 72 may also be referred to as a copper pillar (copper pillar).

In the plurality of conductive pillars 72, extension directions of the conductive pillars 72 are the same, and the extension directions of the conductive pillars 72 are perpendicular to the second surface 1B. A surface of a side that is of the conductive pillar 72 and that is close to the packaging substrate 1 is connected to the second surface 1B. For example, the conductive pillar 72 and the second surface 1B of the packaging substrate 1 are electrically connected through a solder dot preform.

Further, a spacing between the second surface 1B and a surface of a side that is of the conductive pillar 72 and that is away from the packaging substrate 1 is greater than a spacing between the second surface 1B and a surface of a side that is of the second chip 22 and that is away from the packaging substrate 1. In other words, relative to the second surface 1B, the surface of the side that is of the conductive pillar 72 and that is away from the packaging substrate 1 protrudes from the surface of the side that is of the second chip 22 and that is away from the packaging substrate 1. When a thickness of a passive component connected to the second surface 1B is greater than a thickness of the second chip 22, the spacing between the second surface 1B and the surface of the side that is of the conductive pillar 72 and that is away from the packaging substrate 1 is greater than a spacing between the second surface 1B and a surface of a side that is of the passive component and that is away from the packaging substrate 1. In other words, relative to the second surface 1B, the surface of the side that is of the conductive pillar 72 and that is away from the packaging substrate 1 protrudes from the surface of the side that is of the passive component and that is away from the packaging substrate 1. In this way, the conductive pillar 72 is electrically connected to the circuit board 500.

Optionally, in the elevating assembly 7, the plurality of conductive pillars 72 may be arranged according to an actual product requirement. This is not limited in this embodiment of this application.

With reference to FIG. 5, FIG. 6, and FIG. 7, the elevating assembly 7 further includes a fastening layer 71. A material of the fastening layer 71 includes an insulation material. Optionally, the material of the fastening layer 71 includes but is not limited to a liquid crystal polymer (liquid crystal polymer, LCP), an inorganic material (for example, a ceramic material), and the like.

The fastening layer 71 is, for example, in a thin film shape, and extends in a direction parallel to the second surface 1B. In a direction perpendicular to the second surface 1B, a thickness of the fastening layer 71 is less than a height of the conductive pillar 72.

The fastening layer 71 surrounds a partial side surface of each conductive pillar 72. It may also be considered that each conductive pillar 72 penetrates the fastening layer 71. The fastening layer 71 is in contact with only the partial side surface of the conductive pillar 72, and is fastened to the conductive pillar 72, but is not completely in contact with the side surface of the conductive pillar 72, and does not wrap the conductive pillar 72. The fastening layer 71 fastens different conductive pillars 72 together, to limit displacement of different conductive pillars 72, so that the fastening layer 71 and the plurality of conductive pillars 72 fastened by the fastening layer 71 form a module.

Therefore, in the chip packaging structure 600 provided in some embodiments of this application, the elevating assembly 7 is disposed on the second surface 1B of the packaging substrate 1, and an I/O end of the packaging substrate 1 may be led out by using the conductive pillar 72 in the elevating assembly 7, and electrically connected to the circuit board 500. This means that in this embodiment of this application, the solder ball may be replaced with the solder dot preform between the conductive pillar 72 and the packaging substrate 1, and the elevating board may be replaced with the conductive pillar 72, so that problems caused by the solder ball and the elevating board can be eliminated, a yield of the chip packaging structure 600 can be improved, and the elevating assembly 7 in this embodiment of this application can be used in both a scenario with a large elevating height and a scenario with a small spacing between balls (for example, the ball spacing is less than 0.35 mm).

In addition, in this embodiment of this application, the fastening layer 71 is disposed, and the fastening layer 71 is used to surround a partial side surface of each conductive pillar 72, to fasten each conductive pillar 72. The elevating assembly 7 including the fastening layer 71 and the plurality of conductive pillars 72 may be used as an independent module. In this way, in a process of electrically connecting the conductive pillar 72 to the packaging substrate 1, the elevating assembly 7 may be used as a single part for operation, and then the plurality of conductive pillars 72 in the elevating assembly 7 may be soldered to the packaging substrate 1 at a time, thereby alleviating a phenomenon like tilting, falling-down, or bending of the conductive pillar 72 caused by one-by-one mounting of the conductive pillar 72, avoiding damage to the conductive pillar 72, improving a yield of the chip packaging structure 600, and improving a yield of soldering between the chip packaging structure 600 and the circuit board 500.

In addition, the conductive pillar 72 has a small volume, and the conductive pillar 72 has small impact on water washing, thereby avoiding a risk of the solder ball in design and a process. The fastening layer 71 is prepared and formed by using a material like a liquid crystal polymer or an inorganic material, and therefore, costs are low. This can avoid greatly increasing preparation costs of the chip packaging structure 600.

In some embodiments, there may be one or more (for example, two, three, four, or even more) of the elevating assemblies 7.

When there is one elevating assembly 7, the elevating assembly 7 is block-shaped and is located on a side of the second chip 22. Alternatively, the elevating assembly 7 is in a hollow frame structure and surrounds the second chip 22.

With reference to FIG. 5, FIG. 6, and FIG. 7, when there are a plurality of elevating assemblies 7, quantities of conductive pillars 72 in different elevating assemblies 7 may be the same or different, and arrangement manners of the conductive pillars 72 in different elevating assemblies 7 may be the same or different.

In addition, the plurality of elevating assemblies 7 are located on at least two sides of the second component 2 (for example, the second chip 2 shown in the figure). In other words, the plurality of elevating assemblies 7 may be located on two opposite sides, three sides, or a peripheral side of the second chip 22. The different elevating assemblies 7 are spaced.

For example, in FIG. 6, there are two elevating assemblies 7, and the two elevating assemblies 7 are disposed on two opposite sides of the second chip 22. Certainly, the two elevating assemblies 7 may also be disposed on two adjacent sides of the second chip 22.

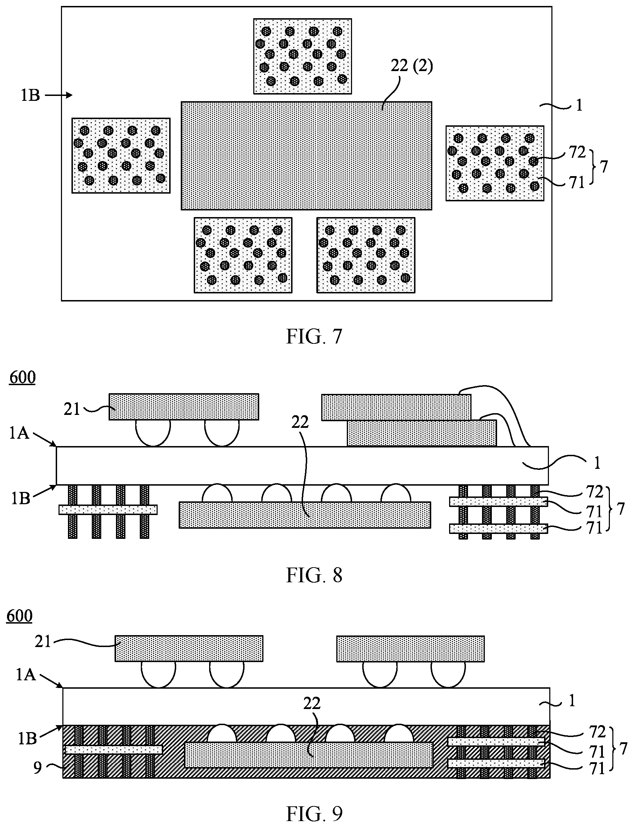

For another example, in FIG. 7, there are five elevating assemblies 7, and the five elevating assemblies 7 are disposed around the periphery side of the second chip 22.

It may be understood that, when there are a plurality of elevating assemblies 7, the plurality of elevating assemblies 7 may separately provide support for the packaging substrate 1. The plurality of elevating assemblies 7 are disposed on at least two sides of the second component, so that the different elevating assemblies 7 can be used to lead out the I/O end of the packaging substrate 1 while forming relatively balanced and stable support for the packaging substrate 1, thereby improving structural stability between the chip packaging structure 600 and the circuit board 500.

In some embodiments, there may be one or more (for example, two, three, four, or even more) fastening layers 71 in the elevating assembly 7. FIG. 5 shows that each of the elevating assemblies 7 includes one fastening layer 71, and FIG. 8 shows that a part of the elevating assemblies 7 include two fastening layers 71.

Still refer to FIG. 8. When there are a plurality of fastening layers 71, the plurality of fastening layers 71 may be spaced apart and stacked in a direction perpendicular to the second surface 1B. Thicknesses of different fastening layers 71 may be equal or may be unequal. The different fastening layers 71 may have equal or unequal orthographic projection areas on the second surface 1B.

Optionally, each fastening layer 71 surrounds a plurality of conductive pillars 72 in the elevating assembly 7, and fastens the plurality of conductive pillars 72.

This helps increase stability or consistency between the conductive pillars 72, improve structural stability of the elevating assembly 7, and further improve a connection yield between the elevating assembly 7 and the packaging substrate 1.

Further, in the plurality of fastening layers 71, a spacing between any two adjacent fastening layers 71 may be set based on an actual requirement. When the second surface 1B of the packaging substrate 1 is molded, a spacing between two adjacent fastening layers 71 should ensure that a molding material can be filled between the two adjacent fastening layers 71, to avoid affecting a yield of the chip packaging structure 600.

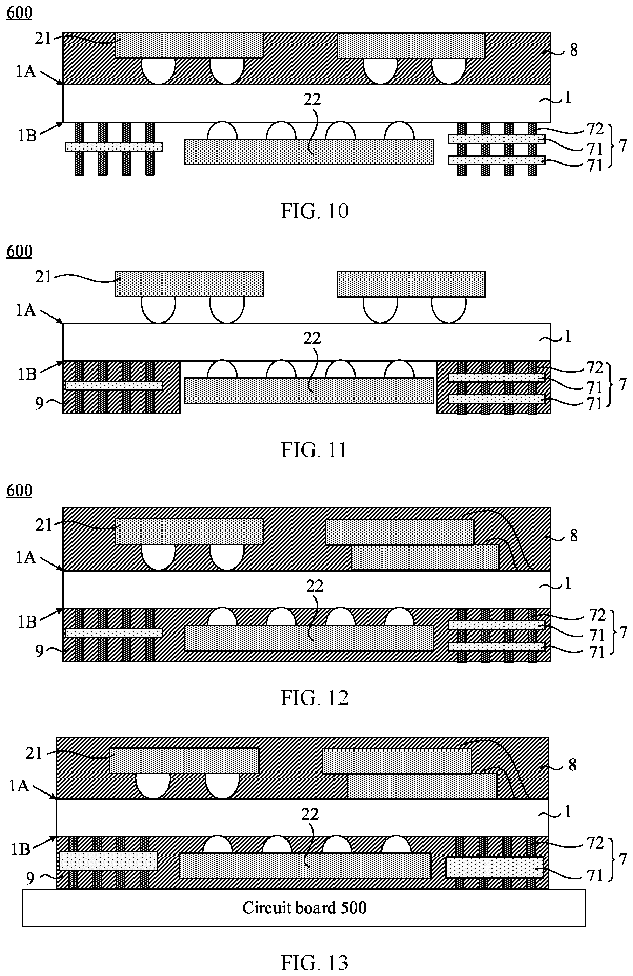

In some embodiments, as shown in FIG. 9 and FIG. 11, there is a gap between the fastening layer 71 and the second surface 1B of the packaging substrate 1. In other words, after the packaging substrate 1 of the elevating assembly 7 is soldered, the fastening layer 71 does not contact the second surface 1B of the packaging substrate 1. On a side that is of the fastening layer 71 and that is close to the packaging substrate 1, the conductive pillar 72 protrudes from the fastening layer 71. A surface of a side that is of the conductive pillar 72 and that is close to the packaging substrate 1 is not wrapped by the fastening layer 71.

In this way, the surface of the side that is of the conductive pillar 72 and that is close to the packaging substrate 1 can be in an exposed state, to facilitate soldering between the conductive pillar 72 and the packaging substrate 1. In addition, as shown in FIG. 11, when the second surface 1B of the packaging substrate 1 is molded, because the fastening layer 71 has been cured and formed in advance, it can be ensured that a molding material can flow and fill into the gap between the fastening layer 71 and the second surface 1B of the packaging substrate 1, thereby improving a yield of the chip packaging structure 600.

Optionally, the spacing between the fastening layer 71 and the second surface 1B of the packaging substrate 1 may be set based on an actual requirement.

In some embodiments, as shown in FIG. 9 and FIG. 13, a spacing between the second surface 1B and a surface of a side that is of the conductive pillar 72 and that is away from the packaging substrate 1 is greater than a spacing between the second surface 1B and a surface of a side that is of the fastening layer 71 and that is away from the packaging substrate 1. That is, on the side that is of the fastening layer 71 and that is away from the packaging substrate 1, the conductive pillar 72 protrudes from the fastening layer 71. The surface of the side that is of the conductive pillar 72 and that is away from the packaging substrate 1 is not wrapped by the fastening layer 71.

As shown in FIG. 13, in this way, the surface of the side that is of the conductive pillar 72 and that is away from the packaging substrate 1 can be in an exposed state, to facilitate soldering between the conductive pillar 72 and the circuit board 500.

In some embodiments, as shown in FIG. 9 to FIG. 12, the chip packaging structure 600 further includes a second packaging layer 8 and/or a first packaging layer 9. In other words, the chip packaging structure 600 may include only the second packaging layer 8, or may include only the first packaging layer 9, or may include both the second packaging layer 8 and the first packaging layer 9. The second packaging layer 8 is located on the first surface 1A of the packaging substrate 1, and the first packaging layer 9 is located on the second surface 1B of the packaging substrate 1.

The second packaging layer 8 at least surrounds a first component (for example, the first chip 21 shown in the figure). For example, as shown in FIG. 10, when the first chip 21 is mounted flat on the packaging substrate 1, the second packaging layer 8 may surround a side wall of the first chip 21, and a surface of a side that is of the first chip 21 and that is away from the packaging substrate 1 is exposed. For another example, as shown in FIG. 12 and FIG. 13, when a plurality of first chips 21 are stacked and are electrically connected to the packaging substrate 1 through a wire, the second packaging layer 8 not only surrounds the side wall of the first chip 21, but also covers the surface of the side that is of the first chip 21 and that is away from the packaging substrate 1.

In this way, the second packaging layer 8 can be used to package the first component, provide physical protection for the first component, and fasten the first component on the packaging substrate 1, thereby improving structural stability between the first component and the packaging substrate 1 and improving reliability of the chip packaging structure 600.

The first packaging layer 9 is at least filled in a gap between two adjacent conductive pillars 72, and surrounds a side surface of each conductive pillar 72. As shown in FIG. 11, the first packaging layer 9 wraps side surfaces of the conductive pillars 72. In a direction perpendicular to the second surface 1B, a thickness of the first packaging layer 9 is, for example, the same as a height of the conductive pillar 72. Further, in the direction perpendicular to the second surface 1B, a thickness of the fastening layer 71 is less than the thickness of the first packaging layer 9. In orthographic projection onto the second surface 1B, an orthographic projection area of the fastening layer 71 is less than an orthographic projection area of the first packaging layer 9. The first packaging layer 9 wraps the fastening layer 71, and covers a side surface of the fastening layer 71. The first packaging layer 9 is further filled between the fastening layer 71 and the second surface 1B of the packaging substrate 1. When there are a plurality of fastening layers 71, the first packaging layer 9 is further filled in a gap between two adjacent fastening layers 71. The first packaging layer 9 exposes a surface of a side that is of the conductive pillar 72 and that is away from the packaging substrate 1.

Optionally, as shown in FIG. 9, FIG. 12, and FIG. 13, the first packaging layer 9 further surrounds a second component (for example, the second chip 22 shown in the figure), and covers a surface of a side that is of the second component (for example, the second chip 22 shown in the figure) and that is away from the packaging substrate 1.

In this way, the first packaging layer 9 can be used to package the second component and the elevating assembly 7, which not only provides physical protection for the second component and the elevating assembly 7, but also fastens the second component and the elevating assembly 7 on the packaging substrate 1, to improve structural stability between the second component and the packaging substrate 1, and improve structural stability between the elevating assembly 7 and the packaging substrate 1. This helps improve quality and a yield of the chip packaging structure 600.

Optionally, any one of the second packaging layer 8 and the first packaging layer 9 may be formed by using a compression molding process, a transfer molding process, a liquid sealing molding process, a vacuum lamination process, or a spin coating process. A material of either of the second packaging layer 8 and the first packaging layer 9 includes but is not limited to polyimide, silicone gel, epoxy resin, and the like.

In some examples, a material of the first packaging layer 9 is different from a material of the fastening layer 71. In this case, there is a clear boundary between the first packaging layer 9 and the fastening layer 71.

Optionally, the material of the first packaging layer 9 and the material of the fastening layer 71 are materials of different types. For example, the material of the first packaging layer 9 is an organic insulation material, and the material of the fastening layer 71 is an inorganic insulation material. Alternatively, the material of the first packaging layer 9 is an organic insulation material, and the material of the fastening layer 71 is an LCP.

Optionally, the materials of the first packaging layer 9 and the fastening layer 71 are both resin materials, but the materials of the first packaging layer 9 and the fastening layer 71 have different filling materials.

An embodiment of this application further provides a manner of elevating the packaging substrate 1. As shown in FIG. 9 and FIG. 11, the chip packaging structure 600 further includes the elevating assembly 7 and the first packaging layer 9. Both the elevating assembly 7 and the first packaging layer 9 are connected to the second surface 1B of the packaging substrate 1.

The elevating assembly 7 includes the fastening layer 71 and a plurality of conductive pillars 72. A quantity of elevating assemblies 7, a disposing position of the elevating assemblies 7, a quantity of the fastening layers 71, a disposing manner of the fastening layers 71, a position relationship between the fastening layers 71 and the second surface 1B of the packaging substrate 1, a connection manner and an arrangement manner of the conductive pillars 72, and a position relationship between a surface of a side that is of the conductive pillar 72 and that is away from the packaging substrate 1 and the second surface 1B are the same as related descriptions in some of the foregoing embodiments. Details are not described herein again.

Still refer to FIG. 9 and FIG. 11. The first packaging layer 9 is at least filled in a gap between two adjacent conductive pillars 72, and surrounds a side surface of each conductive pillar 72. As shown in FIG. 11, the first packaging layer 9 wraps side surfaces of the conductive pillars 72. In a direction perpendicular to the second surface 1B, a thickness of the first packaging layer 9 is, for example, the same as a height of the conductive pillar 72. Further, in the direction perpendicular to the second surface 1B, a thickness of the fastening layer 71 is less than the thickness of the first packaging layer 9. In orthographic projection onto the second surface 1B, an orthographic projection area of the fastening layer 71 is less than an orthographic projection area of the first packaging layer 9. The first packaging layer 9 wraps the fastening layer 71, and covers a side surface of the fastening layer 71. The first packaging layer 9 is further filled between the fastening layer 71 and the second surface 1B of the packaging substrate 1. When there are a plurality of fastening layers 71, the first packaging layer 9 is further filled in a gap between two adjacent fastening layers 71. The first packaging layer 9 exposes a surface of a side that is of the conductive pillar 72 and that is away from the packaging substrate 1.

Optionally, as shown in FIG. 9, FIG. 12, and FIG. 13, the first packaging layer 9 further surrounds a second component (for example, the second chip 22 shown in the figure), and covers a surface of a side that is of the second component (for example, the second chip 22 shown in the figure) and that is away from the packaging substrate 1.

In this way, in the chip packaging structure 600 provided in this embodiment of this application, an I/O end of the packaging substrate 1 may be led out by using the conductive pillar 72 in the elevating assembly 7, and electrically connected to the circuit board 500. This means that in this embodiment of this application, the solder ball may be replaced with the solder dot preform between the conductive pillar 72 and the packaging substrate 1, and the elevating board may be replaced with the conductive pillar 72, so that problems caused by the solder ball and the elevating board can be eliminated, a yield of the chip packaging structure 600 can be improved, and the elevating assembly 7 in this embodiment of this application can be used in both a scenario with a large elevating height and a scenario with a small spacing between balls (for example, the ball spacing is less than 0.35 mm).

In addition, in this embodiment of this application, the elevating assembly 7 including the fastening layer 71 and the plurality of conductive pillars 72 may be used as an independent module. In this way, in a process of electrically connecting the conductive pillar 72 to the packaging substrate 1, the elevating assembly 7 may be used as a single part for operation, and then the plurality of conductive pillars 72 in the elevating assembly 7 may be soldered to the packaging substrate 1 at a time, thereby alleviating a phenomenon like tilting, falling-down, or bending of the conductive pillar 72 caused by one-by-one mounting of the conductive pillar 72, and avoiding damage to the conductive pillar 72. Then, the first packaging layer 9 may be disposed on the second surface 1B, is filled in a gap between two adjacent conductive pillars 72, and wraps the fastening layer 71, to improve structural stability between the elevating assembly 7 and the packaging substrate 1, thereby improving quality and a yield of the chip packaging structure 600.

The material of the fastening layer 71 includes a plurality of types, and may be selected and set based on an actual requirement (for example, an electrical performance requirement, a moisture-proof requirement, or an anticorrosion requirement).

Optionally, the material of the fastening layer 71 includes but is not limited to insulation materials such as a liquid crystal polymer, a resin material (epoxy), and an inorganic material.

Certainly, the material of the fastening layer 71 may further include a material used for support, like a metal material. In this case, an insulation material is disposed between the support material and the conductive pillar 72.

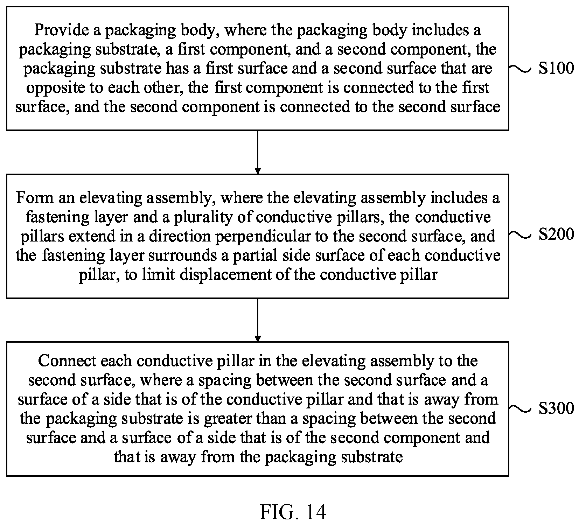

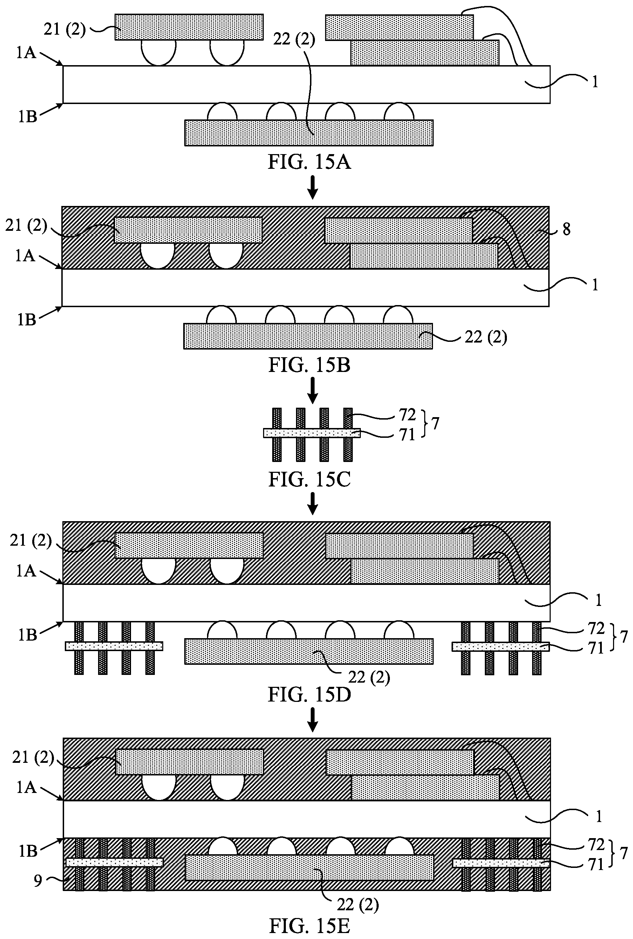

Some embodiments of this application further provide a preparation method for a chip packaging structure. The preparation method is, for example, used to prepare the chip packaging structure 600 in any one of the foregoing embodiments. FIG. 14 is a flowchart of a preparation method for a chip packaging structure according to some embodiments of this application. FIG. 15A, FIG. 15B, FIG. 15C, FIG. 15D, FIG. 15E, FIG. 16A, FIG. 16B, FIG. 17A, and FIG. 17B are respectively diagrams of structures corresponding to steps in the preparation method for the chip packaging structure according to some embodiments. It should be understood that the steps shown in FIG. 14 are not exclusive, and other steps may be performed before, after, or between any steps shown in the figure. In addition, some of the steps may be performed simultaneously, or may be performed in a sequence different from that shown in FIG. 14.

In some embodiments, as shown in FIG. 14, the preparation method for a chip packaging structure includes S100 to S300.

S100: As shown in FIG. 15A, provide a packaging body. The packaging body includes a packaging substrate 1, a first component (for example, a first chip 21 in the figure), and a second component (for example, a second chip 22 in the figure). The packaging substrate 1 has a first surface 1A and a second surface 1B that are opposite to each other, the first chip 21 is connected to the first surface 1A, and the second chip 22 is connected to the second surface 1B.

A structure or a type of any one of the packaging substrate 1, the first chip 21, and the second chip 22, and an arrangement manner of the first chip 21 and the second chip 22 are the same as related content in some of the foregoing embodiments, and details are not described herein again.

For example, a method for forming the packaging body includes: first, connecting the first chip 21 to the first surface 1A of the packaging substrate 1 by using an SMT process; and then, connecting the second chip 22 to the second surface 1B of the packaging substrate 1 by using an SMT process.

As shown in FIG. 15B, when the packaging body further includes a second packaging layer 8, before the second chip 22 is soldered to the second surface 1B, the method for forming the packaging body further includes: performing molding on the first chip 21 to form the second packaging layer 8, where the second packaging layer 8 is in contact with the first surface 1A and covers the first chip 21; and then grinding (grinding) a surface of a side that is of the second packaging layer 8 and that is away from the packaging substrate 1, and flattening the second packaging layer 8 or exposing a surface of a side that is of the first chip 21 and that is away from the packaging substrate 1.

S200: As shown in FIG. 15C, form an elevating assembly 7. The elevating assembly 7 includes a fastening layer 71 and a plurality of conductive pillars 72. The conductive pillars 72 extend in a direction perpendicular to the second surface 1B. The fastening layer 71 surrounds a partial side surface of each conductive pillar 72, to limit displacement of the conductive pillar 72.

In some examples, a method for forming the elevating assembly 7 includes S210 and S220.

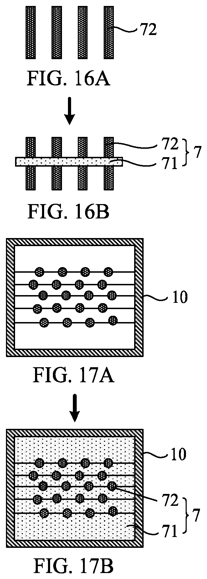

S210: As shown in FIG. 16A and FIG. 17A, provide the plurality of conductive pillars 72. The plurality of conductive pillars 72 are spaced, and all the conductive pillars 72 extend in a same direction. In other words, axes of the conductive pillars 72 are disposed in parallel to each other.

The plurality of conductive pillars 72 may be arranged based on an arrangement manner of the I/O end to be soldered. For example, heights of different conductive pillars 72 are the same. Radial sizes of different conductive pillars 72 may be the same or different.

S220: As shown in FIG. 16B and FIG. 17B, form the fastening layer 71 that surrounds a partial side surface of each conductive pillar 72.

For example, before the fastening layer 71 is formed, a plurality of conductive pillars 72 may be first arranged based on an actual product requirement, and the plurality of conductive pillars 72 are vertically connected to a thin film, or the plurality of conductive pillars 72 are connected to a beam or a support plate of a frame 10 as shown in FIG. 17A, and then the plurality of conductive pillars 72 are placed in an accommodating cavity.

Further, under a condition of high temperature and high pressure (the temperature and the pressure may be set based on an actual requirement), a fastening material is filled into the accommodating cavity. In this case, the fastening material has a specific fluidity, and can flow into a gap between any two adjacent conductive pillars 72. After the fastening material surrounds a partial side surface of each conductive pillar 72 and has a specific thickness, curing processing is performed on the thin film, to form the fastening layer 71. In addition, the fastening layer 71 can fasten each conductive pillar 72.

By adjusting a location of the filled fastening material, a formation location of the fastening layer 71 may be adjusted, and a plurality of fastening layers 71 may be formed and stacked.

It may be understood that, when a height of each conductive pillar 72 is small or a thickness of the fastening layer 71 is small, a strength of the elevating assembly 7 is low. By disposing the frame 10 or the support plate, the beam or the support plate may be used to support the conductive pillar 72. This helps enhance the strength of the elevating assembly 7, and facilitates soldering the conductive pillars 72 in the elevating assembly 7 to the packaging substrate 1. A material of the frame 10 or the support plate includes but is not limited to a metal material, and can support the conductive pillar 72.

Certainly, the method for forming the elevating assembly 7 is not limited thereto. For example, in this embodiment of this application, the fastening layer 71 may be first formed, and then the conductive pillars 72 passes through the fastening layer 71.

S300: As shown in FIG. 15D, connect each conductive pillar 72 in the elevating assembly 7 to the second surface 1B. A spacing between the second surface 1B and a surface of a side that is of the conductive pillar 72 and that is away from the packaging substrate 1 is greater than a spacing between the second surface 1B and a surface of a side that is of a second component (for example, the second chip 22 in the figure) and that is away from the packaging substrate 1.

For example, in this embodiment of this application, the SMT process may be used to simultaneously connect each conductive pillar 72 in the elevating assembly 7 to the second surface 1B of the packaging substrate 1.

Therefore, according to the preparation method provided in some embodiments of this application, the conductive pillar 72 is connected to the fastening layer 71 to form the elevating assembly 7, and the fastening layer 71 can be used to fasten the conductive pillar 72, so that the elevating assembly 7 including the fastening layer 71 and the plurality of conductive pillars 72 is used as an independent module. Further, in a process of connecting the conductive pillar 72 to the second surface 1B of the packaging substrate 1, the elevating assembly 7 may be used as a single part for operation, so that the plurality of conductive pillars 72 in the elevating assembly 7 may be synchronously connected to the second surface 1B, thereby alleviating a phenomenon like tilting, falling-down, or bending of the conductive pillar 72 caused by one-by-one mounting of the conductive pillar 72. This avoids damage to the conductive pillar 72, improves a yield of the chip packaging structure 600, and improves a yield of soldering between the chip packaging structure 600 and the circuit board 500.

In some examples, as shown in FIG. 15E, the preparation method further includes: forming a first packaging layer 9 on the second surface 1B of the packaging substrate 1. The first packaging layer 9 is at least filled in a gap between two adjacent conductive pillars 72, and surrounds a side surface of each conductive pillar 72. The first packaging layer 9 further wraps the fastening layer 71.

It may be understood that, compared with the first packaging layer 9, the elevating assembly 7 is first connected to the second surface 1B. Correspondingly, compared with the first packaging layer 9, the fastening layer 71 of the elevating assembly 7 is first cured and formed. However, a material of the first packaging layer 9 has a specific fluidity. Therefore, in a process of forming the first packaging layer 9, the material of the first packaging layer 9 flows into a gap between two adjacent conductive pillars 72, flows into a gap between the fastening layer 71 and the second surface 1B, and wraps the fastening layer 71 and the second chip 22. Then, curing processing may be performed to form the first packaging layer 9.

Still refer to FIG. 15E. The first packaging layer 9 formed after the curing process is in contact with the second surface 1B and covers the second chip 22. The first packaging layer 9 wraps the fastening layer 71 inside the first packaging layer 9 and is in contact with a side surface of the conductive pillar 72, and a surface of a side that is of the conductive pillar 72 and that is away from the packaging substrate 1 is exposed outside the first packaging layer 9.

When the first packaging layer 9 covers the surface of the side that is of the conductive pillar 72 and that is away from the packaging substrate 1, a surface of a side that is of the first packaging layer 9 and that is away from the packaging substrate 1 may be further ground, or a portion of a surface of a side of the first packaging layer 9 that covers the conductive pillar 72 and that is away from the packaging substrate 1 may be removed by using a laser etching process, to expose the surface of the side that is of the conductive pillar 72 and that is away from the packaging substrate 1.

It may be understood that, when the frame 10 or the support plate is used in S220, after the first packaging layer 9 is formed, the frame 10 or the support plate may be ground and removed, or the frame 10 or the support plate may be removed through de-soldering.

The material of the first packaging layer 9 may be the same as or different from the material of the fastening layer 71. When the material of the first packaging layer 9 is the same as the material of the fastening layer 71, because the fastening layer 71 is formed by curing first, and the first packaging layer 9 is formed by curing later, there may be a boundary between the first packaging layer 9 and the fastening layer 71. When the material of the first packaging layer 9 is different from the material of the fastening layer 71, refer to the descriptions in some of the foregoing examples. Details are not described herein again.

The foregoing descriptions are merely specific implementations of this application, but are not intended to limit the protection scope of this application. Any variation or replacement readily figured out by a person skilled in the art within the technical scope disclosed in this disclosure shall fall within the protection scope of this application. Therefore, the protection scope of this application shall be subject to the protection scope of the claims.

## Claims

1. A chip packaging structure, wherein the chip packaging structure comprises:
a packaging substrate, having a first surface and a second surface that are opposite to each other;
a first component connected to the first surface; and
a second component and an elevating assembly that are connected to the second surface; wherein
the elevating assembly comprises a fastening layer and a plurality of conductive pillars, the conductive pillars extend in a direction perpendicular to the second surface, the fastening layer surrounds a partial side surface of each conductive pillar, to limit displacement of the conductive pillar, and a material of the fastening layer comprises a liquid crystal polymer or an inorganic material;
a surface of a side that is of the conductive pillar and that is close to the packaging substrate is connected to the second surface; and
a spacing between the second surface and a surface of a side that is of the conductive pillar and that is away from the packaging substrate is greater than a spacing between the second surface and a surface of a side that is of the second component and that is away from the packaging substrate.

2. The chip packaging structure according to claim 1, wherein there are a plurality of elevating assemblies; and the plurality of elevating assemblies are located on at least two sides of the second component.

3. The chip packaging structure according to claim 1 or 2, wherein there are a plurality of fastening layers; and the plurality of fastening layers are spaced apart and stacked in the direction perpendicular to the second surface.

4. The chip packaging structure according to any one of claims 1 to 3, wherein there is a gap between the fastening layer and the second surface.

5. The chip packaging structure according to any one of claims 1 to 4, wherein the spacing between the second surface and the surface of the side that is of the conductive pillar and that is away from the packaging substrate is greater than a spacing between the second surface and a surface of a side that is of the fastening layer and that is away from the packaging substrate.

6. The chip packaging structure according to any one of claims 1 to 5, wherein the chip packaging structure further comprises a first packaging layer; and
the first packaging layer is connected to the second surface, is at least filled in a gap between two adjacent conductive pillars, and surrounds each conductive pillar; and the first packaging layer further wraps the fastening layer.

7. A chip packaging structure, wherein the chip packaging structure comprises:
a packaging substrate, having a first surface and a second surface that are opposite to each other;
a first component connected to the first surface; and
a second component, an elevating assembly, and a first packaging layer that are connected to the second surface; wherein
the elevating assembly comprises a fastening layer and a plurality of conductive pillars, the conductive pillars extend in a direction perpendicular to the second surface, and the fastening layer surrounds a partial side surface of each conductive pillar, to limit displacement of the conductive pillar;
a surface of a side that is of the conductive pillar and that is close to the packaging substrate is connected to the second surface;
a spacing between the second surface and a surface of a side that is of the conductive pillar and that is away from the packaging substrate is greater than a spacing between the second surface and a surface of a side that is of the second component and that is away from the packaging substrate; and
the first packaging layer is at least filled in a gap between two adjacent conductive pillars, and surrounds each conductive pillar; and the first packaging layer further wraps the fastening layer.

8. The chip packaging structure according to claim 7, wherein there are a plurality of elevating assemblies; and the plurality of elevating assemblies are located on at least two sides of the second component.

9. The chip packaging structure according to claim 7 or 8, wherein there are a plurality of fastening layers; and the plurality of fastening layers are spaced apart and stacked in the direction perpendicular to the second surface.

10. The chip packaging structure according to any one of claims 7 to 9, wherein there is a gap between the fastening layer and the second surface.

11. The chip packaging structure according to any one of claims 7 to 10, wherein the spacing between the second surface and the surface of the side that is of the conductive pillar and that is away from the packaging substrate is greater than a spacing between the second surface and a surface of a side that is of the fastening layer and that is away from the packaging substrate.

12. The chip packaging structure according to any one of claims 7 to 11, wherein a material of the fastening layer comprises a liquid crystal polymer, a resin material, or an inorganic material.

13. A preparation method for a chip packaging structure, wherein the preparation method comprises:
providing a packaging body, wherein the packaging body comprises a packaging substrate, a first component, and a second component, the packaging substrate has a first surface and a second surface that are opposite to each other, the first component is connected to the first surface, and the second component is connected to the second surface;
forming an elevating assembly, wherein the elevating assembly comprises a fastening layer and a plurality of conductive pillars, the conductive pillars extend in a direction perpendicular to the second surface, and the fastening layer surrounds a partial side surface of each conductive pillar, to limit displacement of the conductive pillar; and
connecting each conductive pillar in the elevating assembly to the second surface, wherein a spacing between the second surface and a surface of a side that is of the conductive pillar and that is away from the packaging substrate is greater than a spacing between the second surface and a surface of a side that is of the second component and that is away from the packaging substrate.

14. The preparation method according to claim 13, wherein forming the elevating assembly comprises:
providing a plurality of conductive pillars; and the plurality of conductive pillars are spaced, and each conductive pillar extends in a same direction; and
forming the fastening layer that surrounds the partial side surface of each conductive pillar.

15. The preparation method according to claim 13, wherein the preparation method further comprises:
forming a first packaging layer on the second surface, wherein the first packaging layer is at least filled in a gap between two adjacent conductive pillars and surrounds a side surface of each conductive pillar, and the first packaging layer further wraps the fastening layer.

16. An electronic device, wherein the electronic device comprises:
a circuit board; and
the chip packaging structure according to any one of claims 1 to 12, wherein the chip packaging structure is connected to the circuit board.
